# EUROPEAN PATENT APPLICATION

(11) **EP 2 838 126 A1**
(43) Date of publication of application: **18.02.2015**
(21) Application number: 13775725.8
(22) Date of filing: 10.04.2013
(51) Int. Cl.: H01L 33/48, C08F 2/44, C09J 4/02, C09J 11/04, C09J 11/06

(54) **SEMICONDUCTOR DEVICE, DIE ATTACH MATERIAL, AND METHOD FOR MANUFACTURING SEMICONDUCTOR DEVICE**

(30) Priority: 10.04.2012 JP 2012089337
(71) Applicant: Sumitomo Bakelite Company Limited, Shinagawa-ku Tokyo 140-0002 (JP); Sumitomo Bakelite Singapore Pte. Ltd., Singapore 758069 (SG)
(72) Inventor: MAKIHARA, Koji, Singapore 758069 (SG); LOW, Shuey Seng, Singapore 758069 (SG); MAN, Lynn Sum, Singapore 758069 (SG)
(74) Representative: Müller-Boré & Partner Patentanwälte PartG mbB
(86) International application number: PCT/JP2013/002430
(87) International publication number: WO 2013/153803

(57) **Abstract**

Provided is a semiconductor device (10) comprising: a substrate (1); an adhesive layer (2); and a light emitting diode chip (3), in which the adhesive layer (2) is a cured product of a die attach material, and the die attach material contains at least one resin component (A) selected from the group consisting of a compound (A1) represented by the following formula (1) and an acrylate compound (A2) which has a cycloalkylene group and two or more (meth) acrylic groups and does not have an aromatic ring in one molecule, a silane coupling agent (B), and an inorganic filler (C). 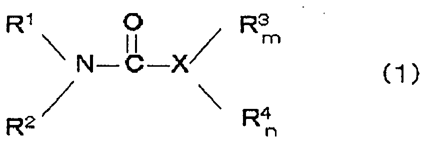 (wherein X represents an oxygen atom or a nitrogen atom; m and n each independently represent 0 or 1; R¹, R², R³, and R⁴ each independently represent a hydrogen atom or an organic group not having an aromatic ring; at least two of R¹, R², R³, and R⁴ each independently represent an organic group having a (meth)acrylic group.)

## Description

### TECHNICAL FIELD

The present invention relates to a semiconductor device, a die attach material, and a method for manufacturing a semiconductor device.

### BACKGROUND ART

In recent years, light emitting diodes (LED) have been used as low-power LEDs (lower than 0.3 W/mK) or middle-power LEDs (0.3 W/mK to 0. 5 W/mK) in various fields such as backlights of mobile phones, fountain lights, spotlights, and liquid crystal display backlights of desktop computers and televisions. In addition, for the LEDs, further expansion of application fields including the use as high-power LEDs (higher than 0.5 W/mK) such as headlights of automobiles is expanded in the future.

Typically, an LED is used as an LED package in which an LED chip is attached to a substrate or a lead frame, through a die attach paste.

Various kinds of die attach pastes used in semiconductor devices are known in the related art (for example, refer to Patent Documents 1 to 3). However, die attach pastes used in LEDs are required to have the following properties to maximize characteristics of LEDs.

### (1) High Light Reflectivity

This property is required to maximize light output of an LED by using the maximum amount of light emitted from the LED to a substrate side.

### (2) High Color Fastness

This property is required to maintain the maximum output of an LED.

### (3) High Elastic Modulus

This property is required because, in the case of a small LED chip, wire bonding cannot be performed at a low elastic modulus.

### (4) High Adhesive Strength

This property is required for an LED chip not to be detached during wire bonding.

As die attach pastes used in LEDs, those containing a silicone resin, an epoxy resin, an acrylic resin, or the like are currently known (for example, refer to Patent Documents 4 to 9).

A die attach paste containing a silicone resin is superior due to its colorlessness and high color fastness but has a problem of low adhesiveness. A die attach paste containing an epoxy resin is superior in adhesiveness but is easily colored and has a problem of low color fastness. A die attach paste containing an acrylic resin is superior in light reflectivity but has problems of low adhesiveness and low elastic modulus.

### RELATED DOCUMENT

### PATENT DOCUMENT

[Patent Document 1] Japanese Unexamined patent publication No.2001-019912
[Patent Document 2] Japanese Unexamined patent publication No.2001-019722
[Patent Document 3] Japanese Unexamined patent publication No.2001-019821
[Patent Document 4] Japanese Unexamined patent publication No.2005-113059
[Patent Document 5] Japanese Unexamined patent publication No.2009-242587
[Patent Document 6] Japanese Unexamined patent publication No.2009-256400
[Patent Document 7] Japanese Unexamined patent publication No.2010-248349
[Patent Document 8] Japanese Unexamined patent publication No.2011-100927
[Patent Document 9] Japanese Unexamined patent publication No.2011-088947

### DISCLOSURE OF THE INVENTION

As a result of a study, the present inventors found that, when being applied to an LED as it is, a die attach paste for a semiconductor device of the related art is not suitably used from the viewpoint of high light reflectivity.

In addition, one of die attach pastes for an LED of the related art is superior due to its colorlessness and high color fastness but has a problem of low adhesiveness, another one thereof is superior in adhesiveness but is easily colored and has a problem of low color fastness, and still another one thereof is superior in light reflectivity but has problems of low adhesiveness and low elastic modulus. Therefore, a die attach paste for an LED which satisfies all the properties (1) to (4) described above in "BACKGROUND ART" is not known.

The present invention has been made in consideration of the above-described circumstances, and an object thereof is to provide a semiconductor device having a good balance between high light reflectivity, high color fastness, high elastic modulus, and high adhesive strength; and a method for manufacturing a semiconductor device.

In order to solve the above-described problems, the present invention adopts the following configurations.

That is, according to a first aspect of the present invention, there is provided a semiconductor device comprising a substrate, an adhesive layer, and a light emitting diode chip, in which the adhesive layer is a cured product of a die attach material, and the die attach material contains at least one resin component (A) selected from the group consisting of a compound (A1) represented by the following formula (1) and an acrylate compound (A2) which has a cycloalkylene group and two or more (meth) acrylic groups and does not have an aromatic ring in one molecule, at least one silane coupling agent (B) selected from the group consisting of a compound (B1) represented by the following formula (b-1) and a compound (B2) represented by the following formula (b-2), and an inorganic filler (C). 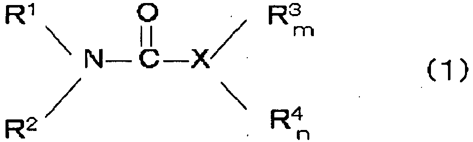 (wherein X represents an oxygen atom or a nitrogen atom; m and n each independently represent 0 or 1; when X represents an oxygen atom, m+n=1; when X represents a nitrogen atom, m+n=2; R¹, R², R³, and R⁴ each independently represent a hydrogen atom or an organic group not having an aromatic ring; at least two of R¹, R², R³, and R⁴ each independently represent an organic group which has a (meth)acrylic group and does not have an aromatic ring; and at least two substituents of R¹, R², R³, and R⁴ may form a ring.)

Y-(CH₂)ₘ-SiR⁵R⁶R⁷ (b-1)

(S)ₙ-((CH₂)ₚ-SiR⁵R⁶R⁷)₂ (b-2)

(wherein R⁵, R⁶, and R⁷ each independently represent an alkyl group having 1 to 10 carbon atoms or an alkoxy group having 1 to 10 carbon atoms; at least one of R⁵, R⁶, and R⁷ represents an alkoxy group having 1 to 10 carbon atoms; Y represents any one of an amino group, a glycidyloxy group, a (meth) acryloyloxy group, a mercapto group, and an isocyanate group; m and p each independently represent an integer of 1 to 10; and n represents an integer of 1 or more.)

In addition, according to a second aspect of the present invention, there is provided a die attach material which is used for attaching a substrate and a light emitting diode chip to each other, the material comprising: at least one resin component (A) selected from the group consisting of a compound (A1) represented by the formula (1) and an acrylate compound (A2) which has a cycloalkylene group and two or more (meth) acrylic groups and does not have an aromatic ring in one molecule; at least one silane coupling agent (B) selected from the group consisting of a compound (B1) represented by the following formula (b-1) and a compound (B2) represented by the following formula (b-2); and an inorganic filler (C).

In the first and second aspects of the present invention, it is preferable that the die attach material be a die attach paste.

In the first and second aspects of the present invention, it is preferable that the compound (A1) contain at least one selected from the group consisting of a compound represented by the following formula (a1-1) and a compound represented by the following formula (a1-2). 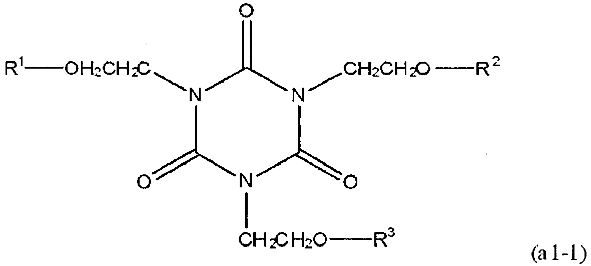 (wherein R¹, R², and R³ each independently represent a hydrogen atom or an organic group not having an aromatic ring; and at least two of R¹, R², and R³ represent an organic group which has a (meth) acrylic group and does not have an aromatic ring.) 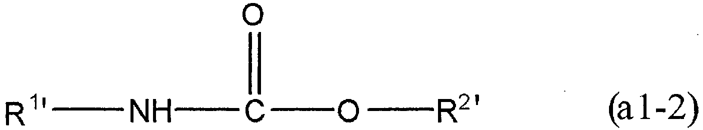 (wherein R^{1'} and R^{2'} each independently represent an organic group which has a (meth) acrylic group and does not have an aromatic ring.)

In the first and second aspects of the present invention, it is preferable that the compound (A1) be a compound having at least three acrylic groups or (meth) acrylic groups in the molecule.

In the first and second aspects of the present invention, it is preferable that the acrylate compound (A2) contain a compound represented by the following formula (a2-1). 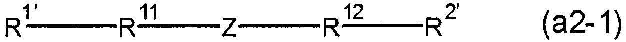 (wherein R^{1'} and R^{2'} each independently represent an organic group which has a (meth) acrylic group and does not have an aromatic ring; R¹¹ and R¹² each independently represent a linear alkylene group or a single bond; and Z represents a cycloalkylene group.)

In the first and second aspects of the present invention, it is preferable that the resin component (A) contain the compound represented by the formula (a1-1).

In the first and second aspects of the present invention, it is preferable that the silane coupling agent (B) contain the compound represented by the formula (b-1).

In the first and second aspects of the present invention, it is preferable that, in the formula (b-1), Y represent a glycidyloxy group or a (meth)acryloyloxy group.

According to a third aspect of the present invention, there is provided a method for manufacturing a semiconductor device, the method comprising: a step of preparing a die attach material by mixing at least one resin component (A) selected from the group consisting of a compound (A1) represented by the formula (1) and an acrylate compound (A2) which has a cycloalkylene group and two or more (meth) acrylic groups and does not have an aromatic ring in one molecule, at least one silane coupling agent (B) selected from the group consisting of a compound (B1) represented by the following formula (b-1) and a compound (B2) represented by the following formula (b-2), and an inorganic filler (C) with each other; a step of applying the die attach material to a substrate or a light emitting diode chip; and a step of attaching the light emitting diode chip to the substrate.

In the third aspect of the present invention, it is preferable that the die attach material be a die attach paste.

In the third aspect of the present invention, it is preferable that the compound (A1) contain at least one selected from the group consisting of a compound represented by the formula (a1-1) and a compound represented by the formula (a1-2).

In the third aspect of the present invention, it is preferable that the compound (A1) be a compound having at least three acrylic groups or (meth) acrylic groups in the molecule.

In the third aspect of the present invention, it is preferable that the acrylate compound (A2) contain a compound represented by the formula (a2-1).

In the third aspect of the present invention, it is preferable that the resin component (A) contain the compound represented by the formula (a1-1).

In the third aspect of the present invention, it is preferable that the silane coupling agent (B) contain the compound represented by the formula (b-1).

In the third aspect of the present invention, it is preferable that, in the formula (b-1), Y represent a glycidyloxy group or a (meth)acryloyloxy group.

According to the present invention, a semiconductor device having a good balance between high light reflectivity, high color fastness, high elastic modulus, and high adhesive strength; and a method for manufacturing a semiconductor device can be provided.

### BRIEF DESCRIPTION OF THE DRAWING

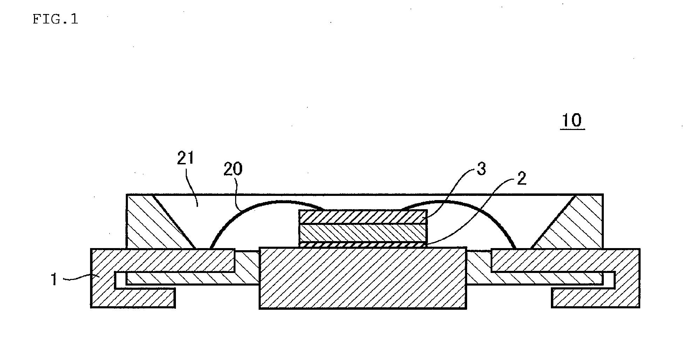

FIG. 1 is a cross-sectional view showing an example of a semiconductor device according to an embodiment of the present invention.

### DESCRIPTION OF EMBODIMENTS

Hereinafter, embodiments of the present invention will be described with reference to the accompanying drawings. In all the drawings, like components are denoted by like reference, and the description thereof will not be repeated.

A semiconductor device according to an embodiment of the present invention comprises a substrate, an adhesive layer, and a light emitting diode chip.

The substrate is not particularly limited, and those used in an LED semiconductor device of the related art can be used.

Specific examples of the substrate include frames in which a surface of copper, a copper alloy, a ceramic, an organic substrate, or the like is plated with silver, gold, a silver alloy, or the like to improve light reflectivity. Among these, a copper frame plated with silver is commonly used and is more preferable.

FIG. 1 is a cross-sectional view showing an example of the semiconductor device according to the embodiment.

For example, as shown in FIG. 1, the semiconductor device 10 according to the embodiment comprises a substrate 1, a light emitting diode chip 3 that is mounted on the substrate 1, and an adhesive layer 2 that is provided between the substrate 1 and the light emitting diode chip 3. In addition, in the semiconductor device 10 according to the embodiment, the substrate 1 and the light emitting diode chip 3 are electrically connected to each other through a bonding wire 20. The light emitting diode chip 3 and the bonding wire 20 are encapsulated with a transparent encapsulation resin 21.

In the semiconductor device according to the embodiment, the adhesive layer contains a cured product of a die attach material containing the following components:
at least one resin component (A) (hereinafter, referred to as "(A) component") selected from the group consisting of a compound (A1) (hereinafter, referred to as "(A1) component") represented by the formula (1) and an acrylate compound (A2) (hereinafter, referred to as "(A2) component") which has a cycloalkylene group and two or more (meth)acrylic groups and does not have an aromatic ring in one molecule;
at least one silane coupling agent (B) (hereinafter, referred to as "(B) component") selected from the group consisting of a compound (B1) (hereinafter, referred to as "(B1) component") represented by the formula (b-1) and a compound (B2) (hereinafter, referred to as "(B2) component") represented by the formula (b-2); and
an inorganic filler (C) (hereinafter, referred to as " (C) component").

Hereinafter, each component of the die attach material will be described.

The die attach material according to the embodiment may be a die attach film or a die attach paste. In addition, it is preferable that the die attach material according to the embodiment be a die attach paste.

Hereinafter, the die attach material according to the embodiment will be described using the die attach paste as an example.

### < (A) Component>

The (A) component is a resin component containing the (A1) component and/or the (A2) component.

The (A1) component is a compound represented by the following formula (1). 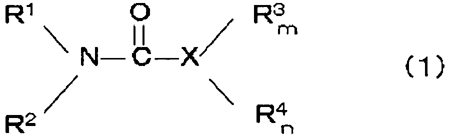 (wherein X represents an oxygen atom or a nitrogen atom; m and n each independently represent 0 or 1; when X represents an oxygen atom, m+n=1; when X represents a nitrogen atom, m+n=2; R¹, R², R³, and R⁴ each independently represent a hydrogen atom or an organic group not having an aromatic ring; at least two of R¹, R², R³, and R⁴ each independently represent an organic group which has a (meth)acrylic group and does not have an aromatic ring; and at least two substituents of R¹, R², R³, and R⁴ may form a ring.)

In the formula (1), X represents an oxygen atom or a nitrogen atom, and m and n each independently represent 0 or 1. In this case, when X represents an oxygen atom, m+n=1, and when X represents a nitrogen atom, m+n=2. It is preferable that X represent a nitrogen atom.

In the formula (1), R¹, R², R³, and R⁴ each independently represent a hydrogen atom or an organic group not having an aromatic ring. In this case, at least two of R¹, R², R³, and R⁴ each independently represent an organic group which has a (meth)acrylic group and does not have an aromatic ring. Examples of the organic group of R¹, R², R³, and R⁴ include organic groups derived from the following: a reactant between polyisocyanate not having an aromatic ring and a compound which does not have an aromatic ring and has one hydroxyl group and one or more (meth) acrylic groups in the molecule; a reactant between a compound which does not have an aromatic ring and has one isocyanate group and one or more (meth) acrylic groups in the molecule and polyol not having an aromatic ring; a reactant between polyisocyanate not having an aromatic ring and a compound which does not have an aromatic ring and has one amino group and one or more (meth) acrylic groups in the molecule; a reactant between a compound which does not have an aromatic ring and has one isocyanate group and one or more (meth) acrylic groups in the molecule and polyamine not having an aromatic ring; and a compound having a (meth) acrylic group in a substituent on a nitrogen atom of an isocyanurate ring.

Specific examples of the polyisocyanate not having an aromatic ring include aliphatic diisocyanates, such as trimethylene diisocyanate, tetramethylene diisocyanate, hexamethylene diisocyanate, pentamethylene diisocyanate, 1,2-propylene diisocyanate, 2,3-butylene diisocyanate, 1, 3-butylene diisocyanate, dodecamethylene diisocyanate, and 2,4,4-trimethylhexamethylene diisocyanate; and alicyclic diisocyanates such as 3-isocyanatomethyl-3,5,5-trimethylcyclohexyl isocyanate (also known as isophorone diisocyanate), 1,3-cyclopentane diisocyanate, 1,3-cyclohexane diisocyanate, 1,4-cyclohexane diisocyanate, methyl-2,4-cyclohexane diisocyanate, methyl-2,6-cyclohexane diisocyanate, 4,4'-methylene bis(cyclohexyl isocyanate), 1,3-bis(isocyanatomethyl)cyclohexane, 1,4-bis(isocyanatomethyl)cyclohexane, hydrogenated xylylene diisocyanate, and hydrogenated diphenylmethane diisocyanate.

Examples of the compound which does not have an aromatic ring and has one hydroxyl group and one or more (meth) acrylic groups in the molecule include aliphatic (meth)acrylates having one hydroxyl group in the molecule such as 2-hydroxyethyl (meth)acrylate, 2-hydroxypropyl (meth)acrylate, 2-hydroxybutyl (meth)acrylate, 4-hydroxybutyl (meth)acrylate, and pentaerythritol tri(meth)acrylate; polyalkylene ether mono(meth)acrylates having one hydroxyl group in the molecule such as polyethylene glycol mono(meth)acrylate and poly(caprolactone) glycol mono(meth)acrylate; and polyester mono(meth)acrylates.

Further, examples of the compound which does not have an aromatic ring and has one isocyanate group and one or more (meth)acrylic groups in the molecule include aliphatic acrylates having one isocyanate group and one or more (meth)acrylic groups in the molecule such as 2-(meth)acryloyloxy ethyl isocyanate, and 1,1-(bisacryloyloxy methyl)ethyl isocyanate.

Examples of the polyol not having an aromatic ring include aliphatic glycols such as ethylene glycol, propylene glycol, diethylene glycol, dipropylene glycol, butylene glycol, 1,6-hexanediol, 3-methyl-1,5-pentane glycol, neopentyl glycol, and hexane triol; aliphatic polyols such as trimethylolpropane and pentaerythritol; polyalkylene ether glycols such as polyethylene glycol; polyester glycols such as poly(caprolactone)glycol; and compounds having a hydroxyalkyl group in a substituent on a nitrogen atom of an isocyanurate ring such as tris(2-hydroxyethyl)isocyanurate.

Examples of the polyamine not having an aromatic ring include aliphatic diamines such as trimethylene diamine, tetramethylene diamine, hexamethylene diamine, pentamethylene diamine, 1,2-propylenediamine, 2,3-butylenediamine, 1,3-butylenediamine, dodecamethylene diamine, and 2,4,4-trimethyl hexamethylene diamine; alicyclic diamines such as 3-aminomethyl-3,5,5-trimethyl cyclohexylamine (also known as isophorone diamine), 1,3-cyclopentanediamine, 1,3-cyclohexanediamine, 1,4-cyclohexanediamine, methyl-2,4-cyclohexanediamine, methyl-2,6-cyclohexanediamine, 4,4'-methylene bis(cyclohexylamine), 1,3-bis(aminomethyl)cyclohexane, and 1,4-bis(aminomethyl)cyclohexane; and aliphatic polyamines such as spermine and spermidine.

Examples of the compound having a (meth) acrylic group in a substituent on a nitrogen atom of an isocyanurate ring include (tris(2-hydroxyethyl)isocyanurate triacrylate, di(2-acryloyloxy ethyl)isocyanurate, and ε-caprolactone-modified tris(2-acryloyloxy ethyl) isocyanurate, but the compounds are not limited thereto. The compounds of the present invention also include a compound into which a (meth)acrylic group is introduced by a condensation reaction between 2-hydroxyethyl isocyanurate or isocyanuric acid and (meth) acrylic acid or (meth) acrylic acid halide; and a compound in which a (meth)acrylic group is introduced, by a condensation reaction of (meth)acrylic acid or (meth)acrylic acid halide, into a terminal of a compound obtained by allowing a hydroxyl group of 2-hydroxyethyl isocyanurate, polyalkylene glycol, and polyester glycol to react with each other.

Among these, tris (2-hydroxyethyl)isocyanurate triacrylate (SR-368, manufactured by Sartomer Company, Inc.), pentaerythritol triacrylate hexamethylene diisocyanate urethane prepolymer, pentaerythritol triacrylate hexamethylene diisocyanate urethane prepolymer (UA-306H, manufactured by Kyoeisha Chemical Co. , Ltd.), pentaerythritol triacrylate isophorone diisosyanate urethane prepolymer (UA-306I, manufactured by Kyoeisha Chemical Co., Ltd.), dipentaerythritol pentaacrylate hexamethylene diisocyanate urethane prepolymer (UA-510H, manufactured by Kyoeisha Chemical Co., Ltd.), ε-caprolactone-modified tris(2-acryloyloxy ethyl)isocyanurate (A-9300-1CL, manufactured by Shin-Nakamura Chemical Co., Ltd.), tris(2-acryloyloxy ethyl)isocyanurate, and di(2-acryloyloxy ethyl)isocyanurate are preferable.

In the formula (1), at least two substituents of R¹, R², R³, and R⁴ may form a ring. In this case, it is preferable that X represent a nitrogen atom.

It is preferable that the (A1) component contain at least one selected from the group consisting of a compound represented by the following formula (a1-1) and a compound represented by the following formula (a1-2), and it is particularly preferable that the (A1) component contain the compound represented by the following formula (a1-1). 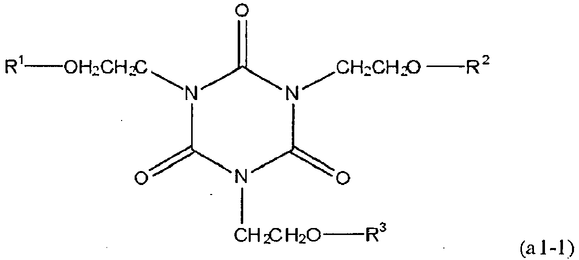 (wherein R¹, R², and R³ each independently represent a hydrogen atom or an organic group not having an aromatic ring; and at least two of R¹, R², and R³ represent an organic group which has a (meth) acrylic group and does not have an aromatic ring.) 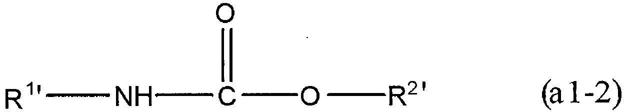 (wherein R^{1'} and R^{2'} each independently represent an organic group which has a (meth) acrylic group and does not have an aromatic ring.)

In the formula (a1-1), R¹, R², and R³ each independently represent a hydrogen atom or an organic group not having an aromatic ring and have the same definition as in the formula (1). As the organic group of R¹, R², and R³, a (meth) acryloyl group, a lactone-modified (meth)acryloyl group, a polyalkylene glycol (meth)acryloyl group are preferable; a (meth)acryloyl group and a lactone-modified (meth)acryloyl group are more preferable; and a (meth)acryloyl group is particularly preferable.

At least two of R¹, R², and R³ represent an organic group which has a (meth) acrylic group and does not have an aromatic ring, and it is preferable that all of R¹, R², and R³ represent an organic group which has a (meth) acrylic group and does not have an aromatic ring.

In the formula (a1-2), R^{1'} and R^{2'} each independently represent an organic group which has a (meth) acrylic group and does not have an aromatic ring and have the same definition as the organic group of R¹, R², and R³. In the formula (a1-2), as the organic group of R^{1'} and R^{2'}, organic groups derived from pentaerythritol triacrylate hexamethylene diisocyanate urethane prepolymer, pentaerythritol triacrylate toluene diisocyanate urethane prepolymer, pentaerythritol triacrylate isophorone diisocyanate urethane prepolymer, and dipentaerythritol pentaacrylate hexamethylene diisocyanate urethane prepolymer are preferable; organic groups derived from pentaerythritol triacrylate hexamethylene diisocyanate urethane prepolymer and pentaerythritol triacrylate isophorone diisocyanate urethane prepolymer are more preferable; and an organic group derived from pentaerythritol triacrylate hexamethylene diisocyanate urethane prepolymer is particularly preferable.

In addition, it is preferable that the compound (A1) represented by the formula (1) be a compound having at least three acrylic groups or (meth) acrylic groups in the molecule. As a result, a semiconductor device having a better balance between high light reflectivity, high color fastness, high elastic modulus, and high adhesive strength can be realized.

The (A2) component is an acrylate compound which has a cycloalkylene group and two or more (meth)acrylic groups and does not have an aromatic ring in one molecule.

It is preferable that the (A2) component be a compound represented by the following formula (a2-1). 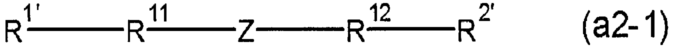 (wherein R^{1'} and R^{2'} each independently represent an organic group which has a (meth) acrylic group and does not have an aromatic ring; R¹¹ and R¹² each independently represent a linear alkylene group or a single bond; and Z represents a cycloalkylene group.)

In the formula (a2-1), R^{1'} and R^{2'} each independently represent an organic group which has a (meth) acrylic group and does not have an aromatic ring and have the same definition as above. In the formula (a2-1), as the organic group of R^{1'} and R^{2'}, a (meth) acryloxy group, an alkyl (meth) acryloxy group, and a polyalkylene glycol (meth) acryloxy group are preferable; a (meth)acryloxy group and an alkyl (meth)acryloxy group are more preferable; and a (meth)acryloxy group is particularly preferable.

In the formula (a2-1), R¹¹ and R¹² each independently represent a linear alkylene group or a single bond. Examples of the linear alkylene group of R¹¹ and R¹² include a methylene group, an ethylene group, and a trimethylene group.

As R¹¹ and R¹², a linear alkylene group is preferable, and it is particularly preferable that all of R¹¹ and R¹² represent a methylene group.

In the formula (a2-1), Z represents a cycloalkylene group. The cycloalkylene group may be monocyclic or polycyclic but is preferably polycyclic. The number of carbon atoms in the cycloalkylene group is preferably more than or equal to 6, more preferably more than or equal to 8, and still more preferably more than or equal to 10.

Specific examples of the cycloalkylene group include a cyclopentylene group, a cyclohexylene group, and tricyclodecylene group. Among these, a cyclohexylene group and a tricyclodecylene group are preferable, and a tricyclodecylene group is particularly preferable.

As such a compound, for example, tricylodecane dimethanol diacrylate (A-DCP, manufactured by Shin-Nakamura Chemical Co. , Ltd.) can be used.

In the embodiment, the content of the resin component (A) contained in the die attach paste is preferably more than or equal to 3 wt% and less than or equal to 20 wt%, more preferably more than or equal to 5 wt% and less than or equal to 16 wt%, and still more preferably more than or equal to 7 wt% and less than or equal to 12 wt%. The reason is as follows. When the content of the resin component (A) is within the above-described range, high adhesive strength and high elastic modulus can be simultaneously realized, and defects are difficult to occur during wire bonding.

### <(B) Component>

The (B) component is at least one silane coupling agent selected from the group consisting of a (B1) component represented by the following formula (b-1) and/or a (B2) component represented by the following formula (b-2).

Y-(CH₂)ₘ-SiR⁵R⁶R⁷ (b-1)

(S)ₙ-((CH₂)ₚ-SiR⁵R⁶R⁷)₂ (b-2)

(wherein R⁵, R⁶, and R⁷ each independently represent an alkyl group having 1 to 10 carbon atoms or an alkoxy group having 1 to 10 carbon atoms; at least one of R⁵, R⁶, and R⁷ represents an alkoxy group having 1 to 10 carbon atoms; Y represents any one of an amino group, a glycidyloxy group, a (meth) acryloyloxy group, a mercapto group, and an isocyanate group; m and p each independently represent an integer of 1 to 10; and n represents an integer of 1 or more.)

In the formulae (b-1) and (b-2), R⁵, R⁶, and R⁷ each independently represent an alkyl group having 1 to 10 carbon atoms or an alkoxy group having 1 to 10 carbon atoms. In this case, at least one of R⁵, R⁶, and R⁷ represents an alkoxy group having 1 to 10 carbon atoms.

The number of carbon atoms in the alkyl group of R⁵, R⁶, and R⁷ is preferably 1 to 8, more preferably 1 to 5, and still more preferably 1 to 3. Specific examples of the alkyl group of R⁵, R⁶, and R⁷ include a methyl group, an ethyl group, and a propyl group. Among these, a methyl group and an ethyl group are preferable, and a methyl group is particularly preferable.

The number of carbon atoms in the alkoxy group of R⁵, R⁶, and R⁷ is preferably 1 to 8, more preferably 1 to 5, and still more preferably 1 to 3. Specific examples of the alkoxy group of R⁵, R⁶, and R⁷ include a methoxy group, an ethoxy group, a propoxy group, and a butoxy group. Among these, a methoxy group, an ethoxy group, and a propoxy group are preferable, and a methoxy group or an ethoxy group is particularly preferable.

At least one of R⁵, R⁶, and R⁷ represents an alkoxy group having 1 to 10 carbon atoms, and it is preferable that at least two of R⁵, R⁶, and R⁷ represent an alkoxy group having 1 to 10 carbon atoms and it is particularly preferable that all of R⁵, R⁶, and R⁷ represent an alkoxy group having 1 to 10 carbon atoms.

In the formula (b-1), Y represents any one of an amino group, a glycidyloxy group, a (meth)acryloyloxy group, a mercapto group, and an isocyanate group. Among these, as Y, an amino group, a glycidyloxy group, a (meth) acryloyloxy group, and a mercapto group are preferable, and a glycidyloxy group or a (meth)acryloyloxy group is particularly preferable.

In the formulae (b-1) and (b-2), m and p each independently represent an integer of 1 to 10, preferably an integer of 1 to 6, and more preferably an integer of 1 to 3.

In the formula (b-2), n represents an integer of 1 or more, preferably an integer more than or equal to 2 and less than or equal to 10, and more preferably an integer more than or equal to 2 and less than or equal to 4.

In the embodiment, it is preferable that the (B) component be the (B1) component from the viewpoints of adhesive strength and reflectance.

In the embodiment, the content of the silane coupling agent (B) contained in the die attach paste is preferably more than or equal to 0.1 wt% and less than or equal to 10 wt%, more preferably more than or equal to 0. 5 wt% and less than or equal to 8 wt%, and still more preferably more than or equal to 1 wt% and less than or equal to 5 wt%. The reason is as follows. When the content of the silane coupling agent (B) is within the above-described range, high adhesive strength can be obtained, and adverse effects caused by voids or bleeding are difficult to occur.

### <(C) Component>

The (C) component is an inorganic filler. The inorganic filler is not particularly limited, and a well-known inorganic filler of the related art can be used. Specific examples of the inorganic filler include conductive fillers such as silver powder, gold powder, nickel powder, and copper powder; and insulating fillers such as aluminum nitride, calcium carbonate, silica, and alumina. These inorganic fillers can be used alone or in a combination of two or more kinds. Among these, a thermally conductive filler of 20 W/m·K or higher is preferably used because thermal conductivity is essential for use in a high-power LED. In addition, when insulating properties are required along with thermal conductivity, alumina, magnesia, boron nitride, and aluminum nitride are more preferably used, and alumina is particularly preferably used.

In the present invention, the content of the inorganic filler (C) contained in the die attach paste is preferably more than or equal to 60 wt% and less than or equal to 90 wt%, more preferably more than or equal to 65 wt% and less than or equal to 85 wt%, and still more preferably more than or equal to 70 wt% and less than or equal to 80 wt%. The reason is as follows. When the content of the inorganic filler (C) is within the above-described range, high workability and thermal conductivity can be obtained.

### <Optional Component>

In the embodiment, as desired, a well-known optional component of the related art can be further added to the die attach paste, in addition to the (A) component, the (B) component, and the (C) component. Specific examples of the optional component include an acrylate resin (hereinafter, referred to as "(D) component") other than the (A) component and an organic peroxide (hereinafter, referred to as "(E) component").

### <(D) Component>

Examples of the acrylate resin as the (D) component include trimethylolpropane trimethacrylate, 2-(meth)acryloyloxyethyl succinic acid, 2-(meth)acryloyloxypropyl succinic acid, 2-(meth)acryloyloxyethyl hexahydrophthalic acid, 2-(meth)acryloyloxypropyl hexahydrophthalic acid, 2-(meth)acryloyloxyethyl methyl hexahydrophthalic acid, 2-(meth)acryloyloxypropyl methyl hexahydrophthalic acid, 2-(meth)acryloyloxyethyl phthalic acid, 2-(meth)acryloyloxypropyl phthalic acid, 2-(meth)acryloyloxyethyl tetrahydrophthalic acid, 2-(meth)acryloyloxypropyl tetrahydrophthalic acid, 2-(meth)acryloyloxyethyl methyl tetrahydrophthalic acid, 2-(meth)acryloyloxypropyl methyl tetrahydrophthalic acid, 2-hydroxy-1,3-di(meth)acryloyloxypropane, tetramethylol methane tri(meth)acrylate, 2-hydroxyethyl (meth)acrylate, 2-hydroxypropyl (meth)acrylate, 2-hydroxybutyl (meth)acrylate, glycerin di(meth)acrylate, 2-hydroxy-3-(meth)acryloyloxypropyl (meth)acrylate, 1,4-cyclohexane dimethanol mono(meth)acrylate, ethyl-α-(hydroxymethyl) (meth)acrylate, 4-hydroxybutyl (meth)acrylate, methyl (meth)acrylate, ethyl (meth)acrylate, n-butyl (meth)acrylate, isobutyl (meth)acrylate, tert-butyl (meth)acrylate, isodecyl (meth)acrylate, lauryl (meth)acrylate, tridecyl (meth)acrylate, cetyl (meth)acrylate, stearyl (meth)acrylate, isoamyl (meth)acrylate, isostearyl (meth)acrylate, behenyl (meth)acrylate, 2-ethylhexyl (meth)acrylate, other alkyl (meth)acrylates, cyclohexyl (meth)acrylate, tert-butyl cyclohexyl (meth)acrylate, tetrahydrofurfuryl (meth)acrylate, benzyl (meth)acrylate, phenoxyethyl (meth)acrylate, isobornyl (meth)acrylate, glycidyl (meth)acrylate, trimethylolpropane tri(meth)acrylate, zinc mono(meth)acrylate, zinc di(meth)acrylate, dimethylaminoethyl (meth)acrylate, diethylaminoethyl (meth)acrylate, neopentyl glycol (meth)acrylate, trifluoroethyl (meth)acrylate, 2,2,3,3-tetrafluoropropyl (meth)acrylate, 2,2,3,3,4,4-hexafluorobutyl (meth)acrylate, perfluorooctyl (meth)acrylate, perfluorooctylethyl(meth)acrylate, ethyleneglycol di(meth)acrylate, propyleneglycol di(meth)acrylate, 1,4-butanediol di(meth)acrylate, 1,6-hexanediol di(meth)acrylate, 1,9-nonanediol di(meth)acrylate, 1,3-butanediol di(meth)acrylate, 1,10-decanediol di(meth)acrylate, tetramethyleneglycol di(meth)acrylate, methoxyethyl (meth)acrylate, butoxyethyl (meth)acrylate, ethoxydiethyleneglycol (meth)acrylate, methoxypolyalkyleneglycol mono(meth)acrylate, octoxypolyalkyleneglycol mono(meth)acrylate, lauroxypolyalkyleneglycol mono(meth)acrylate, stearoxypolyalkyleneglycol mono(meth)acrylate, allyloxypolyalkyleneglycol mono(meth)acrylate, nonylphenoxypolyalkyleneglycol mono(meth)acrylate, N,N'-methylene bis(meth)acrylic amide, N,N'-ethylene bis(meth)acrylic amide, 1,2-di(meth)acrylic amide ethyleneglycol, di(meth)acryloyloxymethyltricyclodecane, 2-(meth)acryloyloxyethyl, N-(meth)acryloyloxyethylmaleimide, N-(meth)acryloyloxyethylhexahydrophthalimide, N-(meth)acryloyloxyethylphthalimide, N-vinyl-2-pyrrolidone, ethoxylated bisphenol A (meth)acrylate, propoxylated bisphenol A (meth)acrylate, a styrene derivative, and a α-methylstyrene derivative. However, the acrylate resin is not limited to these examples. In addition, these acrylate resins may be used in a combination of two or more kinds from the viewpoints of curability, workability, adhesiveness, and the like. The acrylate resin (D) contained in the die attach paste is not an essential component. However, when it is necessary that viscosity, curability, and the like be adjusted, the content of the acrylate resin (D) is preferably more than or equal to 0.1 wt% and less than or equal to 20 wt%, more preferably more than or equal to 0.5 wt% and less than or equal to 15 wt%, and still more preferably more than or equal to 1 wt% and less than or equal to 10 wt%.

### <(E) Component>

Examples of the organic peroxide as the (E) component include 1,1-di(t-butylperoxy)cyclohexane, methyl ethyl ketone peroxide, methyl cyclohexanone peroxide, methyl acetoacetate peroxide, acetylacetone peroxide, 1,1-bis(t-butylperoxy)-3,3,5-trimethylcyclohexane, 1,1-bis(t-hexylperoxy) cyclohexane, 1,1-bis(t-hexylperoxy)-3,3,5-trimethyl cyclohexane, 1,1-bis(t-butylperoxy) cyclohexane, 2,2-bis(4,4-di-t-butylperoxy cyclohexyl)propane, 1,1-bis(t-butylperoxy)cyclododecane, n-butyl 4,4-bis(t-butylperoxy)valerate, 2,2-bis(t-butylperoxy)butane, 1,1-bis(t-butylperoxy)-2-methyl cyclohexane, t-butyl hydroperoxide, P-menthane hydroperoxide, 1,1,3,3-tetramethylbutyl hydroperoxide, t-hexyl hydroperoxide, dicumyl peroxide, 2,5-dimethyl-2,5-bis(t-butylperoxy)hexane, α,α'-bis(t-butylperoxy)diisopropyl benzene, t-butyl cumyl peroxide, di-t-butyl peroxide, 2,5-dimethyl-2,5-bis(t-butylperoxy)hexyne-3, isobutyryl peroxide, 3,5,5-trimethylhexanoyl peroxide, octanoyl peroxide, lauroyl peroxide, cinnamic acid peroxide, m-toluoyl peroxide, benzoyl peroxide, diisopropyl peroxydicarbonate, bis(4-t-butylcyclohexyl)peroxydicarbonate, di-3-methoxybutyl peroxydicarbonate, di-2-ethylhexyl peroxydicarbonate, di-sec-butyl peroxydicarbonate, di(3-methyl-3-methoxybutyl)peroxydicarbonate, di(4-t-butylcyclohexyl)peroxydicarbonate, α,α'-bis(neodecanoylperoxy)diisopropyl benzene, cumyl peroxyneodecanoate, 1,1,3,3-tetramethylbutyl peroxyneodecanoate, 1-cyclohexyl-1-methylethyl peroxyneodecanoate, t-hexyl peroxyneodecanoate, t-butyl peroxyneodecanoate, t-hexyl peroxypivalate, t-butyl peroxypivalate, 2,5-dimethyl-2,5-bis(2-ethylhexanoylperoxy)hexane, 1,1,3,3-tetramethyl butyl peroxy 2-ethyl hexanoate, 1-cyclohexyl-1-methyl ethyl peroxy-2-ethylhexanoate, t-hexylperoxy-2-ethylhexanoate, t-butyl peroxy-2-ethylhexanoate, t-butyl peroxyisobutyrate, t-butyl peroxymaleic acid, t-butylperoxy laurate, t-butylperoxy-3,5,5-trimethyl hexanoate, t-butyl peroxyisopropyl monocarbonate, t-butyl peroxy-2-ethylhexyl monocarbonate, 2,5-dimethyl-2,5-bis (benzoyl peroxy) hexane, t-butylperoxy acetate, t-hexylperoxy benzoate, t-butylperoxy-m-toluoyl benzoate, t-butylperoxy benzoate, bis(t-butylperoxy)isophthalate, t-butylperoxy allyl monocarbonate, and 3,3',4,4'-tetra(t-butyl peroxy carbonyl)benzophenone. These examples can be used alone or can be used in a combination of two or more kinds to control curability.

The content of the organic peroxide (E) contained in the die attach paste is preferably more than or equal to 0 wt% and less than or equal to 0.15 wt%, more preferably more than or equal to 0 wt% and less than or equal to 0.1 wt%, and still more preferably more than or equal to 0 wt% and less than or equal to 0.05 wt%.

In addition, in the die attach paste according to the embodiment, additives such as a curing agent, an organic solvent, a defoaming agent, a surfactant, and an elastomer can be used as desired.

In the embodiment, the die attach paste can be prepared, for example, by preliminarily mixing the respective components with each other, kneading a mixture thereof using a three-roll mill, and defoaming a kneaded product thereof in a vacuum. In addition, it is preferable that solid components be dissolved in an organic solvent before preliminary mixing.

Examples of the organic solvent include ethyl benzoate, propyl benzoate, butyl benzoate, γ-butyrolactone, dibutyl oxalate, dimethyl maleate, diethyl maleate, ethylene glycol monobutyrate, propylene carbonate, N-methylpyrrolidone, 2-(hexyloxy)ethanol, diethylene glycol, diethylene glycol monoethyl ether, diethylene glycol monobutyl ether, triethyl glycol monomethyl ether, dipropylene glycol, tripropylene glycol monomethyl ether, methyl salicylate, diethylene glycol monoethyl ether acetate, and diethylene glycol monobutyl ether acetate. Among these, ethyl benzoate, propyl benzoate, butyl benzoate, γ-butyrolactone, dibutyl oxalate, diethyl maleate, ethylene glycol monobutyrate, propylene carbonate, diethylene glycol, diethylene glycol monobutyl ether, triethyl glycol monomethyl ether, dipropylene glycol, tripropylene glycol monomethyl ether, methyl salicylate, diethylene glycol monoethyl ether acetate, and diethylene glycol monobutyl ether acetate are preferable, and γ-butyrolactone is more preferable.

The die attach paste prepared as described above is applied to a substrate and a light emitting diode chip to attach the light emitting diode chip to the substrate. As a result, the semiconductor device according to the present embodiment can be manufactured. When the die attach material according to the embodiment is a die attach film, the die attach material is interposed between a substrate and a light emitting diode chip to attach the light emitting diode chip to the substrate. As a result, the semiconductor device according to the present embodiment can be manufactured.

The semiconductor device according to the embodiment includes an adhesive layer that contains a cured product of the die attach paste having a good balance between high light reflectivity, high color fastness, high elastic modulus, and high adhesive strength. Therefore, the semiconductor device according to the embodiment can maximize light output and can maintain the maximum light output. In addition, in the semiconductor device according to the embodiment, even an extremely small LED chip can be attached to a substrate or the like without being detached during wire bonding.

The reason why the above-described effects can be obtained is not clear but is presumed to be as follows.

That is, the die attach paste used in the adhesive layer of the semiconductor device according to the embodiment contains the (A1) component and/or the (A2) component as the resin component (A).

The (A1) component has a highly polar NC(=O) skeleton in the structure. Therefore, it is presumed that high adhesive strength can be realized.

In addition, since the (A2) component does not have an aromatic ring, light absorption is low, and thus high light reflectance can be realized. Therefore, it is presumed that the light output of an LED can be maximized by using the maximum amount of light emitted from a light emitting diode chip to a substrate side. In addition, it is presumed that the (A2) component has a cycloalkylene group which is a more rigid skeleton and thus can realize high elastic modulus after curing.

Particularly when the resin component (A) is the compound represented by the formula (a1-1), the resin component (A) has the characteristics of both the (A1) component and the (A2) component. Therefore, a semiconductor device including an adhesive layer that contains a cured product of the die attach paste having a better balance between high light reflectivity, high color fastness, high elastic modulus, and high adhesive strength can be obtained.

In addition, the die attach paste used in the adhesive layer of the semiconductor device according to the embodiment contains a specific silane coupling agent containing the (B1) component and/or the (B2) component.

The (B1) component is a silane coupling agent containing any one of an amino group, a glycidyloxy group, a (meth)acryloyloxy group, a mercapto group, and an isocyanate group, and the (B2) component is a silane coupling agent having a sulfide bond. Particularly, by the addition of the silane coupling agent having a glycidyloxy group and a (meth) acryloyloxy group, high adhesiveness can be imparted to the die attach paste, a varnish component of the die attach paste is not easily colored, and thus high light reflectance can be realized, which is preferable. Two or more kinds of silane coupling agents can be used in combination within a range where adhesiveness and light reflectivity do not deteriorate.

### [Examples]

Hereinafter, the present invention will be described in detail using examples but is not limited thereto.

### <Examples 1 to 5 and Comparative Examples 1 to 3>

The respective components were mixed as shown in Table 1, were kneaded using a three-roll mill, and were defoamed to prepare a die attach paste.

**[Table 1]**

| | | Example | | | | | Comparative Example | | |
|---|---|---|---|---|---|---|---|---|---|
| | | 1 | 2 | 3 | 4 | 5 | 1 | 2 | 3 |
| Resin Component (A) | (A)-1 | 9.0 | 9.0 | 9.0 | | | | 9.0 | |
| | (A)-2 | | | | 9.0 | | | | |
| | (A)-3 | | | | | 9.0 | | | |
| | (A)-4 | | | | | | 6.5 | | |
| | (A)-5 | | | | | | 6.5 | | |
| Silane Coupling Agent (B) | (B)-1 | 3.0 | | 3.0 | 3.0 | 3.0 | 6.5 | | 4.4 |
| | (B)-2 | | 3.0 | | | | | | |
| | (B)-3 | | | | | | | 3.0 | |
| Inorganic Filler (c) | (C)-1 | 73.5 | 73.5 | 73.5 | 73.5 | 73.5 | 73.5 | 73.5 | 73.5 |
| | (C)-2 | 2.5 | 2.5 | 2.5 | 2.5 | 2.5 | 2.5 | 2.5 | 2.5 |
| Acrylate Resin (D) | (D)-1 | 3.0 | 3.0 | 3.0 | 3.0 | 3.0 | | 3.0 | 17.5 |
| | (D)-2 | 1.5 | 1.5 | 1.5 | 1.5 | 1.5 | | 1.5 | 2.2 |
| Organic Peroxide (E) | (E)-1 | | | 0.04 | | | | | |
| Curing Agent (F) | (F)-1 | | | | | | 3.9 | | |
| | (F)-2 | | | | | | 0.4 | | |
| Organic Solvent | (S)-1 | 7.5 | 7.5 | 7.46 | 7.5 | 7.5 | | 7.5 | |
| Catalyst | (G)-1 | | | | | | 0.2 | | |

In Table 1, each symbol represents the following meaning. In addition, the mixing amount of each component is represented by wt%. In addition, each component used in Examples and Comparative Examples is as described below.
(A)-1: tris (2-hydroxyethyl)isocyanurate triacrylate (trade name: SR-368, manufactured by Sartomer Company, Inc.)
(A)-2: pentaerythritol triacrylate hexamethylene diisocyanate urethane prepolymer (trade name: UA-306H, manufactured by Kyoeisha Chemical Co., Ltd.)
(A)-3: tricylodecane dimethanol diacrylate (trade name: A-DCP, manufactured by Shin-Nakamura Chemical Co., Ltd.)
(A)-4: bisphenol F type epoxy resin (trade name: SB-403S, manufactured by Nippon Kayaku Co., Ltd.).
(A)-5: m,p-cresyl glycidyl ether (trade name: m,p-CGE, manufactured by Sakamoto Yakuhin Kogyo Co., Ltd.)

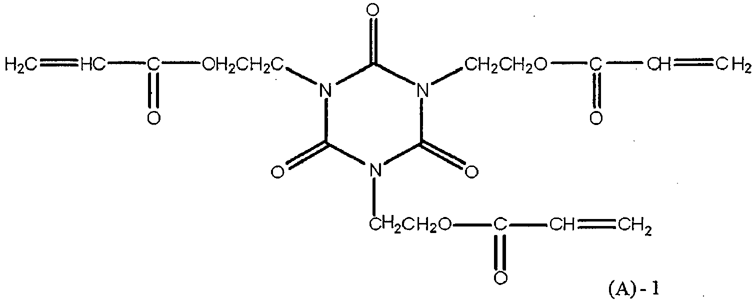

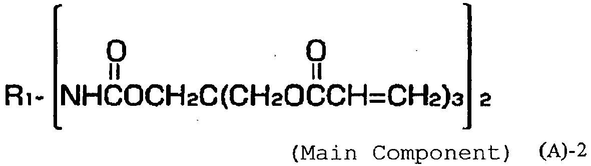

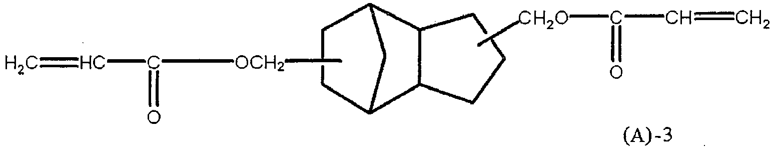

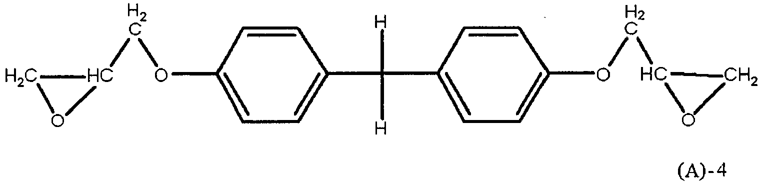

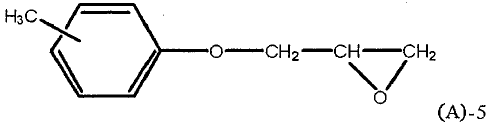

(B)-1: 3-glycidoxypropyl trimethoxysilane (trade name: KBM-403E, manufactured by Shin-Etsu Chemical Co., Ltd.)
(B)-2: 3-methacryloxypropyl trimethoxysilane (trade name: KBM-503P, manufactured by Shin-Etsu Chemical Co. , Ltd.)
(B)-3: 2-(3,4-epoxycyclohexyl)ethyl trimethoxysilane (trade name: KBM-303, manufactured by Shin-Etsu Chemical Co. , Ltd.)

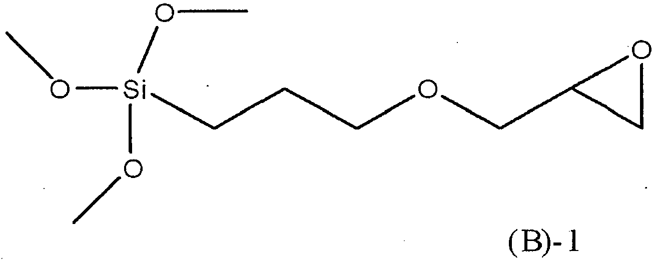

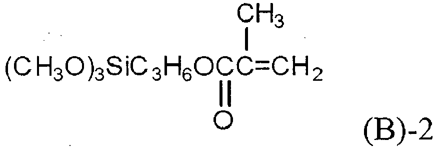

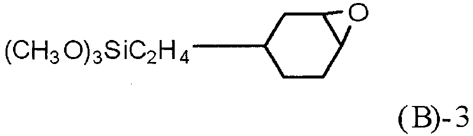

(C)-1: alumina (AX3-15R, manufactured by Nippon Steel Sumikin Materials Co., Ltd., average particle size: 3 µm)
(C)-2: silylated silica (trade name: AEROSIL R805, manufactured by Nippon Aerosil Co., Ltd.)
(D)-1: trimethylolpropane trimethacrylate (trade name: TMP, manufactured by Kyoeisha Chemical Co., Ltd.)
(D)-2: a compound having tetraethylene glycol dimethacrylate as a major component (trade name: LIGHTESTER 4EG, manufactured by Kyoeisha Chemical Co., Ltd.)

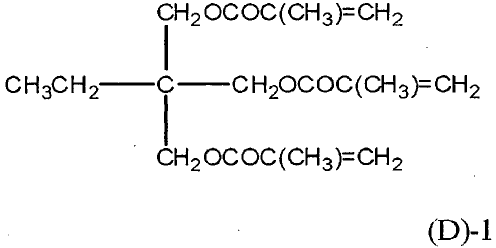

(E)-1: 1,1-di(t-butylperoxy)cyclohexane (trade name: PERHEXA C(S), manufactured by NOF Corporation).
(F)-1: phenol novolac resin (trade name: PR-51470, manufactured by Sumitomo Bakelite Co., Ltd.)
(F)-2: dicyandiamide (trade name: EH3636AS, manufactured by ADEKA Corporation)
(S)-1: γ-butyrolactone
(G)-1: tetraphenylphosphonium tetraphenylborate (trade name: TPP-K, manufactured by Hokko Chemical Industry Co., Ltd.)

The die attach paste prepared in each of Examples and Comparative Examples was evaluated with the following method.

### <Light Reflectivity>

A film-shaped test piece having a size of 6 × 3 × 0.1 mm was prepared (curing conditions: heating time of 30 minutes in a range of 25°C to 175°C and 30 minutes at 175°C), and the light reflectance at a wavelength of 450 nm was measured using a spectrophotometer (trade name: X-rite 8200, manufactured by S.D.G. K.K.).

A reflectance of 60% or higher was evaluated as "A", and a reflectance of lower than 60% was evaluated as "B". The results are shown in Table 2.

### <Ultraviolet Resistance>

The light transmittance at a wavelength of 450 nm (T0) of a sheet-shaped cured product having a thickness of 1 mm (curing conditions: heating time of 30 minutes in a range of 25°C to 175°C and 30 minutes at 175°C) was measured using a spectrophotometer U-4100 (manufactured by Hitachi High-Technologies Corporation). After the cured product was irradiated with ultraviolet rays for 24 hours using an UV irradiating device (illuminance: 100 mW/cm²) equipped with 365-nm band pass filter, the light transmittance (T1) thereof was measured with the same method as above to obtain T1/T0 (%).

A T1/T0 value of 90% or higher was evaluated as "A", and a T1/T0 value of lower than 90% was evaluated as "B". The results are shown in Table 2.

### <Adhesive Strength>

A silicon chip having a size of 0.5 × 0.5 mm was mounted on an Ag-plated copper frame, followed by curing in an oven under curing conditions of a heating time of 30 minutes in a range of 25°C to 175°C and 30 minutes at 175°C. After curing, the die shear strength of the cured product when being heated at 260°C was measured using an automated adhesive strength measuring device. During heating at 260°C, a die shear strength of 5 N or higher was evaluated as "A", a die shear strength of higher than or equal to 3 N and lower than 5 N was evaluated as "B", and a die shear strength of lower than 3 N was evaluated as "C". The results are shown in Table 2.

### <Elastic Modulus>

A film-shaped test piece having a size of 4×20×0.1 mm was prepared (curing conditions: heating time of 30 minutes in a range of 25°C to 175°C and 30 minutes at 175°C), and the elastic modulus thereof was measured using a dynamic viscoelasticity measuring device (DMA) in a pull mode. Measurement conditions were as follows.
Measurement temperature: -100°C to 300°C
Temperature increase rate: 5 °C/min
Frequency: 10 Hz
Load: 100 mN

When the storage modulus at 200°C was obtained as the elastic modulus, an elastic modulus of 800 MPa was evaluated as "A", an elastic modulus of more than or equal to 400 MPa and less than 800 MPa was evaluated as "B", and an elastic modulus of less than 400 MPa was evaluated as "C". The results are shown in Table 2.

### <Comprehensive Evaluation>

Based on the above-described evaluation results, a die attach material which was practically applicable to an LED semiconductor device was evaluated as "A", and a die attach material which was not practically applicable to an LED semiconductor device was evaluated as "B". The results are shown in Table 2.

**[Table 2]**

| | Example | | | | | Comparative Example | | |
|---|---|---|---|---|---|---|---|---|
| Evaluation Items | 1 | 2 | 3 | 4 | 5 | 1 | 2 | 3 |
| Reflectance | A | A | A | A | A | B | A | A |
| Ultraviolet Resistance | A | A | A | A | A | B | A | A |
| Adhesive Strength | A | A | A | A | B | A | C | C |
| Elastic Modulus | A | A | A | B | A | A | A | C |
| Comprehensive Evaluation | A | A | A | A | A | B | B | B |

It was confirmed from the results of Table 2 that the die attach pastes of Examples 1 to 5 were superior in various properties required in an adhesive layer of a LED semiconductor device including reflectance (that is, light reflectivity), ultraviolet resistance (that is, high color fastness), elastic modulus, and adhesive strength; and that a practicable LED semiconductor device was able to be manufactured therefrom. In addition, all of the die attach pastes of Comparative Examples were not practically applicable to an LED semiconductor device.

Particularly in Example 1-3 in which the compound represented by the formula (a1-1) was used as the resin component (A), all the evaluation results were superior. In the structure of the resin component of Example 4, the highly polar NC (=O) skeleton was provided, but a rigid structure was not provided. Therefore, high adhesive strength was able to be achieved, but slightly poor results were exhibited in elastic modulus as compared to Examples 1 to 3. In addition, in the structure of the resin component of Example 5, the rigid cycloalkylene skeleton was provided, but a highly polar functional group was not provided. Therefore, high elastic modulus was able to be achieved, but slightly poor results were exhibited in adhesive strength as compared to Examples 1 to 3.

On the other hand, in Comparative Example 1 in which the epoxy resin was used as the resin component, it was found that reflectance and ultraviolet resistance were poor. The reason is presumed to be that the resin component of Comparative Example 1 contained an aromatic ring having a light absorbing ability in a visual light region and further contained a functional group which was easily oxidized.

In addition, in Comparative Example 2 in which the silane coupling agent represented by the formula (b-3) was used, it was found that adhesiveness was poor although the compound represented by the formula (a1-1) was used as the resin component (A). The reason is presumed to be that, since the silane coupling agent used in Comparative Example 2 had a bulky reactive functional group compared to the coupling agent used in Examples, the reactivity of the resin composition was poor, a superior bond between the resin component and the inorganic filler or between the resin component and an adherend was not able to be obtained.

In addition, in Comparative Example 3 in which the resin component (A) was not provided as the resin component, it was found that adhesive strength and elastic modulus were poor. The reason is presumed to be that the resin component of Comparative Example 3 did not have a highly polar functional group and a rigid structure such as a cycloalkylene skeleton.

Hereinabove, the preferred embodiment of the present invention have been described, but the present invention is not limited to these embodiments. Within a range not departing from the scope of the present invention, additions, omissions, substitutions, and other modifications can be made for the configurations. The present invention is not limited the above description but is only limited to the accompanying claims.

## Claims

1. A semiconductor device comprising:
a substrate;
an adhesive layer; and
a light emitting diode chip,
wherein the adhesive layer is a cured product of a die attach material, and
the die attach material contains
at least one resin component (A) selected from the group consisting of a compound (A1) represented by the following formula (1) and an acrylate compound (A2) which has a cycloalkylene group and two or more (meth) acrylic groups and does not have an aromatic ring in one molecule,
at least one silane coupling agent (B) selected from the group consisting of a compound (B1) represented by the following formula (b-1) and a compound (B2) represented by the following formula (b-2), and
an inorganic filler (C). 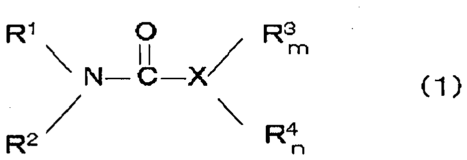
(wherein X represents an oxygen atom or a nitrogen atom; m and n each independently represent 0 or 1; when X represents an oxygen atom, m+n=1; when X represents a nitrogen atom, m+n=2; R¹, R², R³, and R⁴ each independently represent a hydrogen atom or an organic group not having an aromatic ring; at least two of R¹, R², R³, and R⁴ each independently represent an organic group which has a (meth) acrylic group and does not have an aromatic ring; and at least two substituents of R¹, R², R³, and R⁴ may form a ring.)
Y-(CH₂)ₘ-SiR⁵R⁶R⁷ (b-1)
(S) n- ((CH₂)ₚ-SiR⁵R⁶R⁷)₂ (b-2)
(wherein R⁵, R⁶, and R⁷ each independently represent an alkyl group having 1 to 10 carbon atoms or an alkoxy group having 1 to 10 carbon atoms; at least one of R⁵, R⁶, and R⁷ represents an alkoxy group having 1 to 10 carbon atoms; Y represents any one of an amino group, a glycidyloxy group, a (meth)acryloyloxy group, a mercapto group, and an isocyanate group; m and p each independently represent an integer of 1 to 10; and n represents an integer of 1 or more.)

2. The semiconductor device according to claim 1,
wherein the die attach material is a die attach paste.

3. The semiconductor device according to claim 1 or 2,
wherein the compound (A1) contains at least one selected from the group consisting of a compound represented by the following formula (a1-1) and a compound represented by the following formula (a1-2). 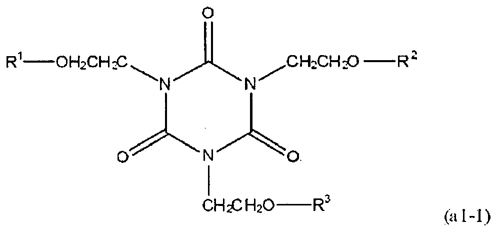 (wherein R¹, R², and R³ each independently represent a hydrogen atom or an organic group not having an aromatic ring; and at least two of R¹, R², and R³ represent an organic group which has a (meth)acrylic group and does not have an aromatic ring.) 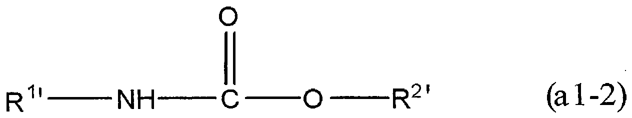 (wherein R^{1'} and R^{2'} each independently represent an organic group which has a (meth) acrylic group and does not have an aromatic ring.)

4. The semiconductor device according to any one of claims 1 to 3,
wherein the compound (A1) is a compound having at least three acrylic groups or (meth)acrylic groups in the molecule.

5. The semiconductor device according to claim 1 or 2,
wherein the acrylate compound (A2) contains a compound represented by the following formula (a2-1). 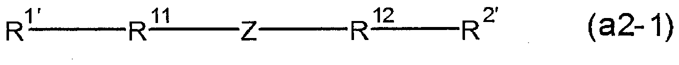 (wherein R^{1'} and R^{2'} each independently represent an organic group which has a (meth) acrylic group and does not have an aromatic ring; R¹¹ and R¹² each independently represent a linear alkylene group or a single bond; and Z represents a cycloalkylene group.)

6. The semiconductor device according to claim 3,
wherein the resin component (A) contains the compound represented by the formula (a1-1).

7. The semiconductor device according to any one of claims 1 to 6,
wherein the silane coupling agent (B) contains the compound represented by the formula (b-1).

8. The semiconductor device according to any one of claims 1 to 7,
wherein in the formula (b-1), Y represents a glycidyloxy group or a (meth)acryloyloxy group.

9. A die attach material which is used for attaching a substrate and a light emitting diode chip to each other, the material comprising:
at least one resin component (A) selected from the group consisting of a compound (A1) represented by the following formula (1) and an acrylate compound (A2) which has a cycloalkylene group and two or more (meth) acrylic groups and does not have an aromatic ring in one molecule;
at least one silane coupling agent (B) selected from the group consisting of a compound (B1) represented by the following formula (b-1) and a compound (B2) represented by the following formula (b-2); and
an inorganic filler (C). 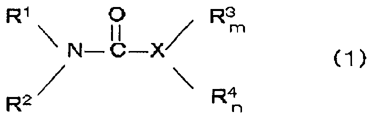
(wherein X represents an oxygen atom or a nitrogen atom; m and n each independently represent 0 or 1; when X represents an oxygen atom, m+n=1; when X represents a nitrogen atom, m+n=2; R¹, R², R³, and R⁴ each independently represent a hydrogen atom or an organic group not having an aromatic ring; at least two of R¹, R², R³, and R⁴ each independently represent an organic group which has a (meth) acrylic group and does not have an aromatic ring; and at least two substituents of R¹, R², R³, and R⁴ may form a ring.)
Y-(CH₂)ₘ-SiR⁵R⁶R⁷ (b-1)
(S)ₙ-((CH₂)ₚ-SiR⁵R⁶R⁷)₂ (b-2)
(wherein R⁵, R⁶, and R⁷ each independently represent an alkyl group having 1 to 10 carbon atoms or an alkoxy group having 1 to 10 carbon atoms; at least one of R⁵, R⁶, and R⁷ represents an alkoxy group having 1 to 10 carbon atoms; Y represents any one of an amino group, a glycidyloxy group, a (meth)acryloyloxy group, a mercapto group, and an isocyanate group; m and p each independently represent an integer of 1 to 10; and n represents an integer of 1 or more.)

10. A method for manufacturing a semiconductor device, the method comprising:
a step of preparing a die attach material by mixing at least one resin component (A) selected from the group consisting of a compound (A1) represented by the following formula (1) and an acrylate compound (A2) which has a cycloalkylene group and two or more (meth) acrylic groups and does not have an aromatic ring in one molecule, at least one silane coupling agent (B) selected from the group consisting of a compound (B1) represented by the following formula (b-1) and a compound (B2) represented by the following formula (b-2), and an inorganic filler (C) with each other;
a step of interposing the die attach material between a substrate and a light emitting diode chip; and
a step of attaching the light emitting diode chip to the substrate. 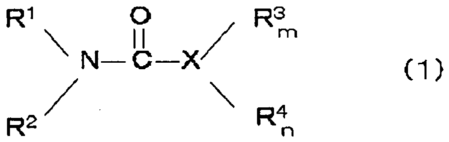
(wherein X represents an oxygen atom or a nitrogen atom; m and n each independently represent 0 or 1; when X represents an oxygen atom, m+n=1; when X represents a nitrogen atom, m+n=2; R¹, R², R³, and R⁴ each independently represent a hydrogen atom or an organic group not having an aromatic ring; at least two of R¹, R², R³, and R⁴ each independently represent an organic group which has a (meth) acrylic group and does not have an aromatic ring; and at least two substituents of R¹, R², R³, and R⁴ may form a ring.)
Y-(CH₂)ₘ-SiR⁵R⁶R⁷ (b-1)
(S)ₙ-((CH₂)ₚ-SiR⁵R⁶R⁷)₂ (b-2)
(wherein R⁵, R⁶, and R⁷ each independently represent an alkyl group having 1 to 10 carbon atoms or an alkoxy group having 1 to 10 carbon atoms; at least one of R⁵, R⁶, and R⁷ represents an alkoxy group having 1 to 10 carbon atoms; Y represents any one of an amino group, a glycidyloxy group, a (meth)acryloyloxy group, a mercapto group, and an isocyanate group; m and p each independently represent an integer of 1 to 10; and n represents an integer of 1 or more.)

11. The method for manufacturing a semiconductor device according to claim 10,
wherein the die attach material is a die attach paste, and in the step of interposing the die attach material, the die attach paste is applied to the substrate and the light emitting diode chip.

12. The method for manufacturing a semiconductor device according to claim 10 or 11,
wherein the compound (A1) contains at least one selected from the group consisting of a compound represented by the following formula (a1-1) and a compound represented by the following formula (a1-2). 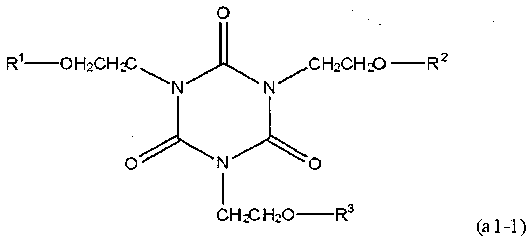 (wherein R¹, R², and R³ each independently represent a hydrogen atom or an organic group not having an aromatic ring; and at least two of R¹, R², and R³ represent an organic group which has a (meth)acrylic group and does not have an aromatic ring.) 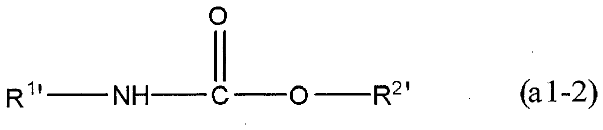 (wherein R¹' and R²' each independently represent an organic group which has a (meth) acrylic group and does not have an aromatic ring.)

13. The method for manufacturing a semiconductor device according to any one of claims 10 to 12,
wherein the compound (A1) is a compound having at least three acrylic groups or (meth)acrylic groups in the molecule.

14. The method for manufacturing a semiconductor device according to claim 10 or 11,
wherein the acrylate compound (A2) contains a compound represented by the following formula (a2-1). 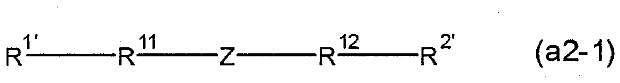 (wherein R^{1'} and R^{2'} each independently represent an organic group which has a (meth) acrylic group and does not have an aromatic ring; R¹¹ and R¹² each independently represent a linear alkylene group or a single bond; and Z represents a cycloalkylene group.)

15. The method for manufacturing a semiconductor device according to claim 12,
wherein the resin component (A) contains the compound represented by the formula (a1-1).

16. The method for manufacturing a semiconductor device according to any one of claims 10 to 15,
wherein the silane coupling agent (B) contains the compound represented by the formula (b-1).

17. The method for manufacturing a semiconductor device according to any one of claims 10 to 16,
wherein in the formula (b-1), Y represents a glycidyloxy group or a (meth)acryloyloxy group.
